Europäisches Patentamt

European Patent Office

Office européen des brevets

(11) Numéro de publication: **0 092 515**
**A1**

## (12) DEMANDE DE BREVET EUROPEEN

(21) Numéro de dépôt: **83810140.0**

(22) Date de dépôt: **08.04.83**

(51) Int. Cl.³: **H 03 H 3/02**, H 03 H 9/19

(30) Priorité: **14.04.82 CH 2247/82**

(43) Date de publication de la demande: **26.10.83**
**Bulletin 83/43**

(84) Etats contractants désignés: **DE FR GB**

(71) Demandeur: **ASULAB S.A., Faubourg du Lac 6, CH-2501 Bienne (CH)**

(72) Inventeur: **Dinger, Rudolf, Charrières 7, CH-2024 St. Aubin (CH)**

(74) Mandataire: **Barbeaux, Bernard et al, c/o ASUAG - Société Générale de l'Horlogerie Suisse S.A. 6, Fraubourg du Lac, CH-2501 Bienne (CH)**

(54) Elément résonateur piézoélectrique et procédé de fabrication de celui-ci.

(57) Elément résonateur (2) obtenu par usinage photo-chimique à partir d'une plaque piézoélectrique mince (10) et présentant sur son pourtour des saillies de cassure (5) entièrement logées à l'intérieur d'encoches (7) de façon que lesdites saillies ne dépassent pas un contour général (6) prédéterminé.

Les saillies (5) proviennent de la cassure à l'endroit de moindre résistance (4) des isthmes (3) qui relient l'élément résonateur (2) au cadre (1) que forme le reste de la plaque piézo-électrique (10) de départ après usinage photo-chimique.

ESA 106

GD/cb

## ELEMENT RESONATEUR PIEZOELECTRIQUE ET PROCEDE DE FABRICATION

## DE CELUI-CI

La présente invention se rapporte aux résonateurs piézoélectriques; elle concerne, plus particulièrement, les éléments résonateurs
utilisés dans les pièces d'horlogerie, ainsi que leur procédé de
fabrication.

Les montres électroniques à quartz, aussi bien analogiques que
numériques, ont marqué ces dernières années une rapide évolution,
tant du point de vue de l'encombrement, de la précision, de la
consommation d'énergie, du nombre de fonctions, que du prix. Cette
évolution a été rendue possible en grande partie grâce aux progrès
réalisés dans les résonateurs et dans leur procédé de fabrication.

L'adoption de la forme en diapason pour les éléments résonateurs
horlogers a permis de résoudre les problèmes liés à la suspension de
ces derniers et de diminuer fortement leurs dimensions tout en leur
assurant des performances élevées, tant du point de vue de la
stabilité en fréquence que de la dissipation d'énergie.

Ainsi, on utilise actuellement pour la fabrication des éléments
résonateurs un procédé d'usinage par attaque photo-chimique analogue
au procédé utilisé en microélectronique. Ce procédé qui est décrit
par exemple dans les brevets US 3,488,530 et US 3,683,213 permet de
fabriquer en même temps un grand nombre d'éléments résonateurs à
partir d'une plaque mince de matériau piézoélectrique, par exemple
de quartz, par étapes successives, ce qui assure un prix de revient
par résonateur très bas.

A la fin de cet usinage, la plaque de quartz contient des centaines d'éléments résonateurs ayant chacun un contour de forme géométrique prédéterminée. Chaque élément résonateur reste toutefois attaché au reste de la plaque par un ou plusieurs isthmes de liaison très étroits, qu'il suffit de casser pour détacher l'élément résonateur du reste de ladite plaque. Cette cassure des isthmes laisse sur une face des éléments résonateurs des aspérités ou saillies dépassant du contour de forme géométrique prédeterminée. Ces saillies rendent cette face impropre à servir comme face de référence pour le positionnement de l'élément résonateur dans un boîtier d'encapsulation. De plus, ces saillies augmentent l'encombrement hors-tout des éléments résonateurs.

C'est pourquoi, un but de la présente invention est de fournir un élément résonateur qui, après sa séparation du reste de la plaque, puisse être inscrit dans ledit contour de forme géométrique prédéterminée.

Pour atteindre ce but, conformément à la présente invention, l'élément résonateur présente sur sa surface un ou plusieurs évidements ou encoches dans lesquelles sont entièrement logées les saillies provenant de la cassure des isthmes de liaison.

Selon un mode de réalisation préféré du procédé de fabrication d'un élément résonateur selon l'invention, on découpe par attaque photo-chimique une plaque mince de départ en matériau piézoélectrique, de manière à réaliser une pluralité d'éléments résonateurs ayant un contour de forme géométrique prédéterminée. Chaque élément est relié au reste de la plaque par au moins un isthme présentant une partie de moindre résistance qui est située à l'intérieur d'une encoche ménagée sur ledit contour, de telle façon que, lors de l'opération de détachement de l'élément résonateur du reste de la plaque, la saillie de cassure de l'isthme se trouve entièrement à l'intérieur de ladite encoche.

Un avantage de l'élément résonateur obtenu selon la présente invention, par rapport aux formes d'exécution connues, se trouve dans le fait que le pourtour de l'élément résonateur après cassure des isthmes ne présente aucune saillie dépassant ledit contour de forme géométrique prédeterminée.

Les dessins annexés illustrent deux arts antérieurs et donnent, à titre d'exemple nullement limitatif, une forme d'exécution d'un élément résonateur selon l'invention; dans ces dessins :

- la fig. 1 représente une plaque de quartz. vue en plan découpée par usinage photo-chimique selon un premier art antérieur;

- la fig. 2a est une vue partielle agrandie d'une plaque de quartz montrant les isthmes reliant un élément résonateur en forme de diapason au cadre que forme la plaque de quartz selon un second art antérieur;

- la fig. 2b montre les cassures formant saillie sur un élément résonateur réalisé selon le procédé illustré par la fig. 2a;

- la fig. 3a représente, en vue en plan, une forme d'exécution selon l'invention d'un élément résonateur en forme de diapason avant son détachement de la plaque de quartz; et

- la fig. 3b représente l'élément résonateur de la fig. 3a, une fois détaché de la plaque de quartz.

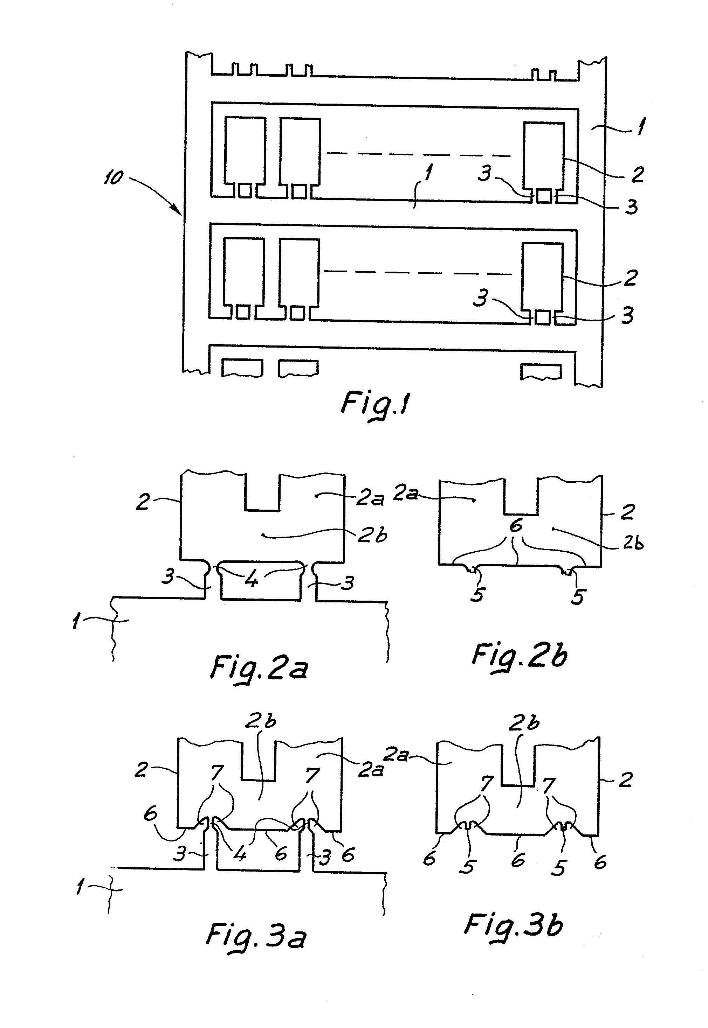

La fig. 1 montre une plaque mince en quartz 10 usinée par attaque photo-chimique selon un art antérieur. Ladite plaque 10

comprend un cadre 1 et un multitude d'éléments résonateurs 2. Chaque élément résonateur 2 est maintenu attaché au cadre 1 par deux isthmes de liaison 3. Dans la forme d'exécution représentée à la fig. 1, les éléments résonateurs 2 ont la forme générale d'un rectangle plein allongé et les isthmes 3 sont constitués par des bandes étroites également de forme rectangulaire. Chaque élément résonateur 2 est, par la suite, détaché du cadre 1 par une cassure des isthmes de liaison 3. Etant donné que la section de chaque isthme 3 est constante sur toute sa longueur, l'endroit de la cassure sera mal localisé.

Pour remédier à cela, on a proposé de donner aux isthmes 3 la forme représentée sur la fig. 2a. Cette figure montre, à une echelle agrandie, la région où un élément résonateur 2 est relié au cadre 1 par deux isthmes 3. Dans cette forme d'exécution, l'élément résonateur 2 a la forme d'un diapason, constitué par deux bras 2a reliés à une base 2b. De cette dernière partent les isthmes 3, en forme de bande, et qui présentent chacun une partie 4 plus étroite et donc de moindre résistance mécanique. Les parties 4 sont situées aussi près que possible de la base 2b de l'élément résonateur 2. De cette façon, la cassure de chaque isthme 3 est bien mieux localisée dans cette forme d'exécution que dans celle représentée sur la fig. 1.

L'élément résonateur 2 de la fig. 2a, une fois détaché du cadre 1, est représenté sur la fig. 2b. Comme on peut le voir sur cette figure, des saillies 5 résultant de la cassure des isthmes 3 dépassent vers l'extérieur le plan général de la face inférieure 6 de l'élément résonateur 2. Ces saillies 5 présentent d'abord l'inconvénient d'augmenter la longueur hors-tout de l'élément résonateur 2. De plus, les saillies 5 font que la face inférieure 6 ne peut plus être utilisée comme surface de référence permettant un positionnement précis de l'élément résonateur 2 dans un boîtier d'encapsulation.

La forme d'exécution d'un élément résonateur selon l'invention représenté sur les figs 3a et 3b permet d'éviter les inconvénients précédemment décrits. On distingue sur la fig. 3a le cadre 1 et l'élément résonateur 2. Deux encoches 7 sont ménagées dans la base 2b à partir de la face inférieure 6. Deux isthmes 3, présentant chacun une partie de moindre résistance 4, relient le cadre 1 à la base 2b de l'élément résonateur 2. La partie de moindre résistance 4 de chaque isthme aboutit directement à la base 2b. La profondeur de chaque encoche 7 est telle que la partie de moindre résistance 4 s'y trouve entièrement logée et ne déborde donc pas du contour général de forme rectangulaire de l'élément résonateur 2, contour qui comprend, du côté de la base 2b, la trace sur le plan de la figure, de la face inférieure 6.

Une fois détaché du cadre 1, l'élément résonateur 2 de la fig. 3a est représenté sur la fig. 3b. Cette dernière figure montre que les saillies de cassure 5 se trouvent entièrement à l'intérieur des encoches 7 et ne débordent donc pas du plan général de la face inférieure 6 de l'élément résonateur 2.

En comparant les figs 2b et 3b, on voit, d'une part, que dans la seconde figure la longueur hors-tout de l'élément résonateur 2 n'est pas augmentée de la dimension des saillies de cassures 5. D'autre part, les saillies 5 étant en retrait par rapport au plan général de la face 6, cette face peut être prise comme surface de référence pour assurer le positionnement précis dudit élement résonateur dans un boîtier, par exemple en appliquant la face 6 sur sur une surface de référence correspondante du boîtier.

Il est clair que la conception qui vient d'être décrite peut également être appliquée à d'autres formes d'éléments résonateurs, d'isthmes et d'évidements que celles qui ont été prises ici comme exemple, pourvu qu'après le détachement de l'élément résonateur, la saillie résultant de la cassure de l'isthme se trouve entièrement à l'intérieur de l'évidement.

REVENDICATIONS

1. Elément résonateur piézoélectrique, notamment pour pièce d'horlogerie, cet élément présentant sur sa surface au moins une saillie de cassure (4), caractérisé en ce que ladite saillie (4) est entièrement située à l'intérieur d'un évidement (7) ménagé dans ladite surface dudit élément résonateur.

· 2. Elément résonateur selon la revendication 1, caractérisé en ce qu'il est de forme plate et en ce que ledit évidement (7) est une encoche ménagée à partir du pourtour (6) dudit élément résonateur.

3. Elément résonateur selon l'une des revendications 1 et 2, caractérisé en ce qu'il est réalisé en quartz.

4. Elément résonateur selon l'une des revendications 2 et 3, caractérisé en ce qu'il présente un pourtour de forme générale rectangulaire allongée et en ce que ladite encoche (7) est située sur l'un des petits côtés (6) dudit pourtour.

5. Elément résonateur selon la revendication 4, caractérisé en ce qu'il est en forme de diapason et en ce que ladite encoche (7) est située sur le petit côté (6) délimitant la base (2b) dudit diapason.

6. Procédé de fabrication d'un élément résonateur piézoélectrique à partir d'une plaque mince (10) en matériau piézoélectrique, procédé selon lequel on découpe par attaque photo-chimique ladite plaque (10) de manière à obtenir une pluralité d'éléments résonateurs (3) dont chacun est relié au reste (1) de la plaque par au moins un isthme (3) de liaison ayant une partie (4) de moindre résistance, caractérisé en ce que ladite partie de moindre résistance (4) est entièrement située dans une encoche (7) de l'élément résonateur piézoélectrique.

0092515

1/1

Fig.1

Fig.2a

Fig.2b

Fig.3a

Fig.3b

0092515

Office européen des brevets

**RAPPORT DE RECHERCHE EUROPEENNE**

Numéro de la demande

EP 83 81 0140

| | **DOCUMENTS CONSIDERES COMME PERTINENTS** | | |
|---|---|---|---|
| Catégorie | Citation du document avec indication, en cas de besoin, des parties pertinentes | Revendication concernée | CLASSEMENT DE LA DEMANDE (Int. Cl. 3) |
| A | PATENTS ABSTRACTS OF JPANA, vol. 3, no. 92, 4 août 1979, page 111 E 128 & JP - A - 54 70791 (CITIZEN TOKEI K.K.) 06-06-1979 * En entier * | 1,2,5, 6 | H 03 H 3/02 H 03 H 9/19 |
| | --- | | |
| A | FR-A-2 232 137 (SUWA SEIKOSHA) * Figure 9; page 1, lignes 1-30; page 8, ligne 19 - page 19, ligne 3 * | 1-3,5, 6 | |
| | ----- | | |
| | | | **DOMAINES TECHNIQUES RECHERCHES (Int. Cl. 3)** |
| | | | H 03 H G 04 F |

Le présent rapport de recherche a été établi pour toutes les revendications

| Lieu de la recherche LA HAYE | Date d'achèvement de la recherche 25-07-1983 | Examinateur COPPIETERS C. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

............................................................

& : membre de la même famille, document correspondant

OEB Form 1503. 03 82